# EUROPEAN PATENT APPLICATION

(11) **EP 4 491 312 A1**
(43) Date of publication of application: **15.01.2025**
(21) Application number: 24183209.6
(22) Date of filing: 19.06.2024
(51) Int. Cl.: B23K 1/00, B23K 1/008, B23K 3/08

(54) **SYSTEM AND METHOD FOR DETERMINING WHETHER TO CLEAN A REFLOW OVEN**

(30) Priority: 26.06.2023 CN 202310763979
(71) Applicant: Illinois Tool Works Inc., Glenview IL 60025 (US)
(72) Inventor: CHEN, Yuexin, Glenview, 60025 (US)
(74) Representative: HGF

(57) **Abstract**

The present disclosure provides a system and method for determining whether to clean a reflow oven. The system comprises a collecting device, a weighing device, and a control device. The collecting device is disposed in a cooling zone, and is configured to collect contaminants. The collecting device is mounted on the weighing device. The weighing device is configured to weigh the collecting device to obtain weight information of the collecting device. The control device is configured to determine whether the reflow oven needs to be cleaned based on the weight information of the collecting device. The method comprises collecting contaminants in a cooling zone by a collecting device, weighing the collecting device to obtain weight information of the collecting device, and determining whether the reflow oven needs to be cleaned based on the weight information of the collecting device. According to the present disclosure, based on determining that the reflow oven needs to be cleaned, a user can be prompted to clean the reflow oven at an appropriate time, thereby improving the production efficiency of the reflow oven and reducing unnecessary downtime.

## Description

### TECHNICAL FIELD

The present disclosure relates to a reflow oven, and in particular, to a system and method for determining whether to clean a reflow oven.

### BACKGROUND

During the manufacture of printed circuit boards, electronic elements are mounted on the circuit boards generally by using a process known as "reflow soldering". In a typical reflow soldering process, solder paste (e.g., tin solder paste) is deposited onto selected areas on a circuit board, and wires of one or more electronic elements are imbedded into the deposited solder paste. The circuit board then passes through a reflow oven. In the reflow oven, the solder paste reflows in a high temperature zone of a hearth of the reflow oven (i.e., being heated to a melting or reflow temperature) and is then cooled in a cooling zone of the hearth to electrically and mechanically connect the wires of the electronic elements to the circuit board. As used herein, the term "circuit board" or "printed circuit board (PCB)" includes a substrate assembly of any type of electronic elements, for example, including a wafer substrate. In the reflow oven, air or a substantially inert gas (e.g., nitrogen) is generally used as a working gas, and different working gases are used for circuit boards having different process requirements. The hearth of the reflow oven is full of the working gas, and the circuit board is soldered under the working gas while being conveyed through the hearth by a conveying device.

### SUMMARY OF THE DISCLOSURE

Tin solder paste includes not only a solder, but also a soldering flux which promotes wetting of the solder and provides a good solder j oint. Other additives such as solvents and catalysts may also be included. After the tin paste is printed on a circuit board, the circuit board is conveyed on a conveyor to pass through a plurality of high temperature zones of a hearth of a reflow oven. Heat in the high temperature zones melts the tin solder paste, and organic compounds containing volatile organic compounds (VOCs), mainly including a soldering flux, are vaporized into vapor, thereby forming "contaminants". These contaminants are mixed with a working gas in the high temperature zones to form a waste gas. The accumulation of these contaminants in the hearth of the reflow oven may cause some problems. For example, when the circuit board is conveyed from the high temperature zones to a cooling zone, the contaminants also flow to the cooling zone, and the contaminants will be condensed into a liquid and/or a solid and drip onto the circuit board after being cooled in the cooling zone, thus contaminating the circuit board. As a result, a subsequent cleaning step has to be performed. Moreover, condensates may also drip onto subsequent circuit boards; consequently, elements on the circuit boards may be damaged, or the contaminated circuit boards have to be cleaned in subsequent steps.

The inventors have found that in the prior art, the reflow oven is cleaned by pre-arranged maintenance. However, the pre-arranged maintenance may be too early or too late, resulting in undesired downtime, thereby lowering the production efficiency.

In order to solve the above problems, the present disclosure provides a system and method for determining whether to clean a reflow oven, in which contaminants are collected in a cooling zone by a collecting device, the collecting device with collected contaminants is weighed to obtain weight information of the collecting device, and whether the reflow oven needs to be cleaned is determined based on the weight information. According to the present disclosure, when it is determined that the reflow oven needs to be cleaned, a user can be prompted to clean and maintain the reflow oven at a reasonable time, thereby improving the production efficiency and reducing undesirable downtime.

According to a first aspect of the present disclosure, the present disclosure provides a system for determining whether to clean a reflow oven. The reflow oven comprises a high temperature zone and a cooling zone. The system comprises a collecting device, a weighing device, and a control device. The collecting device is disposed in the cooling zone, and is configured to collect contaminants. The collecting device is mounted on the weighing device. The weighing device is configured to weigh the collecting device to obtain weight information of the collecting device. The control device is configured to determine whether the reflow oven needs to be cleaned based on the weight information of the collecting device.

According to the first aspect of the present disclosure, the collecting device is disposed in a first cooling sub-zone of the cooling zone, or is disposed in an intermediate zone between the first cooling sub-zone of the cooling zone and a second cooling sub-zone of the cooling zone. The high temperature zone, the first cooling sub-zone and the second cooling sub-zone are disposed in sequence along a conveying direction of a workpiece in the reflow oven.

According to the first aspect of the present disclosure, the weighing device is disposed inside or outside the cooling zone.

According to the first aspect of the present disclosure, the collecting device comprises a collecting surface and a collecting recess. The collecting surface is configured to enable the contaminants to be adhered thereto. The collecting recess is communicated with the collecting surface, and is configured to collect the contaminants flowing from the collecting surface. The collecting surface is a tapered surface.

According to the first aspect of the present disclosure, the collecting surface of the collecting device is configured to have the same material as that of the surface of a reflow oven chamber device in the cooling zone, such that the collecting surface of the collecting device allows the contaminants to be adhered with the same adhesion property as that of the surface of the reflow oven chamber device.

According to the first aspect of the present disclosure, the weighing device is a precision balance.

According to the first aspect of the present disclosure, the control device is configured to compare the weight information of the collecting device with collected contaminants with a collecting device weight threshold, and determine that the reflow oven needs to be cleaned if the weight information of the collecting device with collected contaminants reaches the collecting device weight threshold. The control device is configured to compare weight information of the contaminants collected by the collecting device with a contaminant weight threshold, and determine that the reflow oven needs to be cleaned if the weight information of the contaminants collected by the collecting device reaches the contaminant weight threshold.

According to the first aspect of the present disclosure, the control device is further configured to determine that the reflow oven needs to be cleaned after a predetermined period of time based on the weight information of the collecting device, or to determine that the reflow oven needs to be cleaned immediately based on the weight information of the collecting device.

According to the first aspect of the present disclosure, the control device is a controller of the reflow oven or different from the controller of the reflow oven.

According to the first aspect of the present disclosure, the system further comprises an indicating device. The indicating device is configured to generate an indication indicative of whether the reflow oven needs to be cleaned based on a signal received from the control device. The indication comprises a visual indication or an audible indication.

According to a second aspect of the present disclosure, the present disclosure provides a method for determining whether to clean a reflow oven. The reflow oven comprises a high temperature zone and a cooling zone. The method comprises: collecting contaminants in the cooling zone by a collecting device, weighing the collecting device to obtain weight information of the collecting device, and determining whether the reflow oven needs to be cleaned based on the weight information of the collecting device.

According to the second aspect of the present disclosure, determining whether the reflow oven needs to be cleaned based on the weight information of the collecting device comprises: comparing the weight information of the collecting device with collected contaminants with a collecting device weight threshold; and determining that the reflow oven needs to be cleaned if the weight information of the collecting device with collected contaminants reaches the collecting device weight threshold.

According to the second aspect of the present disclosure, the method further comprises: obtaining initial weight information of the collecting device without collected contaminants; and obtaining a sum of the initial weight information of the collecting device and a contaminant weight threshold as the collecting device weight threshold.

According to the second aspect of the present disclosure, determining whether the reflow oven needs to be cleaned based on the weight information of the collecting device comprises: obtaining weight information of the contaminants collected by the collecting device based on the initial weight information of the collecting device without collected contaminants and weight information of the collecting device with collected contaminants; comparing the weight information of the contaminants collected by the collecting device with a contaminant weight threshold; and determining that the reflow oven needs to be cleaned if the weight information of the contaminants collected by the collecting device reaches the contaminant weight threshold.

According to the second aspect of the present disclosure, the initial weight information of the collecting device without collected contaminants is obtained by: weighing the collecting device without collected contaminants after each cleaning of the reflow oven, so as to obtain the initial weight information of the collecting device.

According to the second aspect of the present disclosure, collecting contaminants in the cooling zone by a collecting device comprises arranging the collecting device in a first cooling sub-zone of the cooling zone, and collecting, by the collecting device, the contaminants adhered thereto. Alternatively, collecting contaminants in the cooling zone by a collecting device comprises arranging the collecting device in an intermediate zone between the first cooling sub-zone of the cooling zone and a second cooling sub-zone of the cooling zone, and collecting, by the collecting device, the contaminants adhered thereto. The high temperature zone, the first cooling sub-zone and the second cooling sub-zone are disposed in sequence along a conveying direction of a workpiece in the reflow oven.

According to the second aspect of the present disclosure, determining whether the reflow oven needs to be cleaned comprises: determining that the reflow oven needs to be cleaned after a predetermined period of time; and determining that the reflow oven needs to be cleaned immediately.

According to the second aspect of the present disclosure, the method further comprises generating an indication indicative of whether the reflow oven needs to be cleaned based on the determination. Generating an indication indicative of whether the reflow oven needs to be cleaned comprises: generating a visual indication or an audible indication indicative of whether the reflow oven needs to be cleaned.

According to a third aspect of the present disclosure, the present disclosure provides a reflow oven, which comprises a system for determining whether to clean a reflow oven as described above.

According to the third aspect of the present disclosure, the present disclosure provides a reflow oven for implementing a method described above.

### BRIEF DESCRIPTION OF THE DRAWINGS

The accompanying drawings are not drawn to scale. In the accompanying drawings, each identical or nearly identical component denoted in different figures is denoted by the same reference number. For the sake of clarity, not every component may be labeled in every figure. In the figures:
Fig. 1A is a perspective view of a reflow oven according to the present disclosure;
Fig. 1B is a perspective view of the reflow oven shown in Fig. 1A with a housing removed;
Fig. 1C is a perspective view of the reflow oven shown in Fig. 1B in an open state;
Fig. 2 is a perspective view of a system for determining whether to clean a reflow oven mounted on a part of the reflow oven according to an embodiment of the present disclosure;
Fig. 3A is a block diagram of a system for determining whether to clean a reflow oven according to an embodiment of the present disclosure;
Fig. 3B is a block diagram of a system for determining cleaning of a reflow oven according to another embodiment of the present disclosure;
Fig. 4 is a perspective view of an embodiment in which a collecting device and a weighing device of the system shown in Fig. 2 are mounted in a reflow oven;
Fig. 5A is a perspective view of another embodiment in which a collecting device and a weighing device of the system shown in Fig. 2 are mounted in a reflow oven;
Fig. 5B is a partial enlarged view of Fig. 5A;
Fig. 6A is a perspective view of a collecting device and a weighing device of the system shown in Fig. 2 when mounted together;
Fig. 6B is a perspective view of the collecting device shown in Fig. 6A;
Fig. 6C is a bottom view of Fig. 6B;
Fig. 6D is a perspective view of the weighing device shown in Fig. 6A;
Fig. 6E is a top view of Fig. 6D;
Fig. 7 is a flowchart of a method for determining whether to clean a reflow oven according to the present disclosure;
Fig. 8A is a detailed flowchart of an embodiment of step 714 shown in Fig. 7;
Fig. 8B is a detailed flowchart of another embodiment of step 714 shown in Fig. 7; and
Fig. 9 is a block diagram of a control device shown in Figs. 3A-3B.

### DETAILED DESCRIPTION OF EMBODIMENTS

Various specific embodiments of the present disclosure are described below with reference to the drawings which constitute part of this specification. It should be understood that although the terms indicating directions, such as "front", "rear", "upper", "lower", "left" and "right" are used in the present disclosure to describe structural parts and elements in various examples of the present disclosure, these terms are used herein only for ease of description and are determined based on the exemplary orientation as shown in the drawings. Since the arrangements in the embodiments disclosed in the present disclosure may be in various directions, these terms indicating directions are only illustrative and should not be considered as limitations.

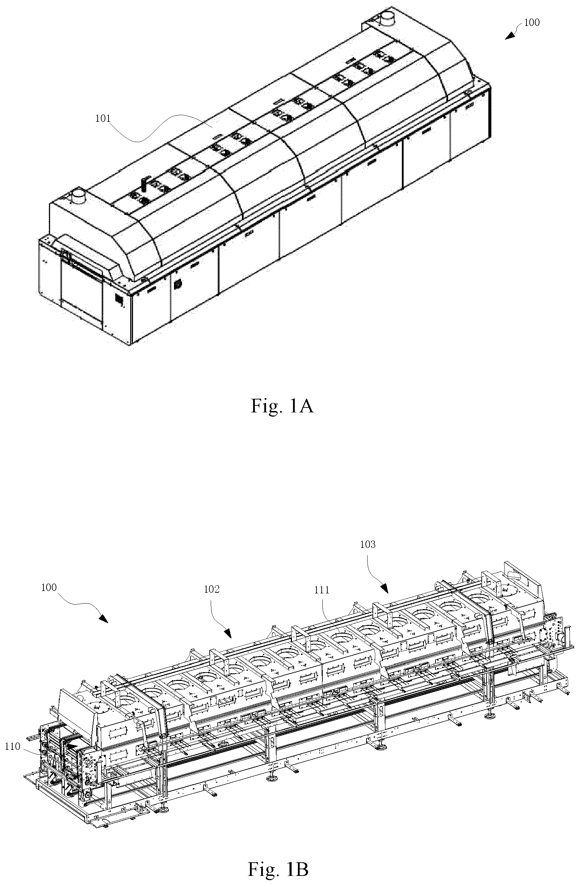

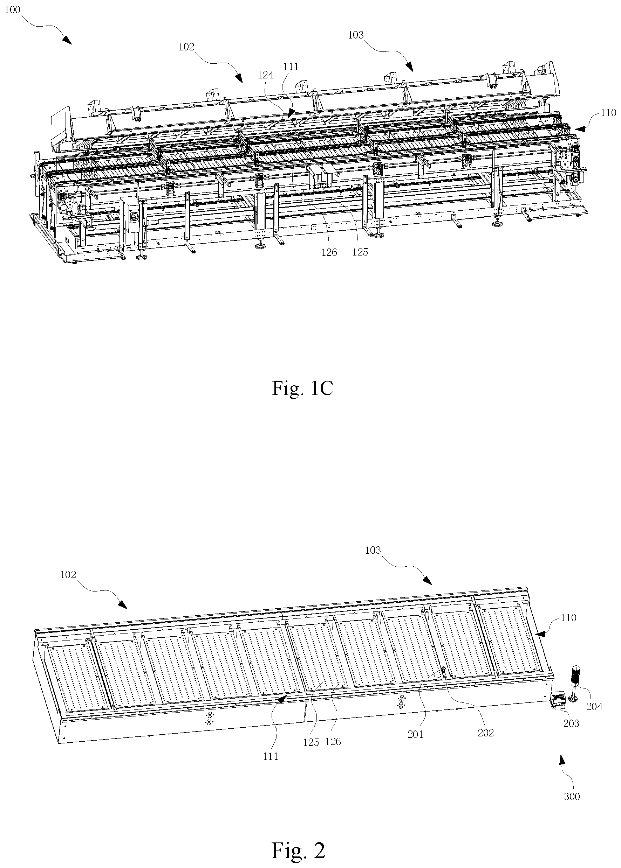

Fig. 1A is a perspective view of a reflow oven 100 according to the present disclosure, Fig. 1B is a perspective view of the reflow oven 100 shown in Fig. 1A with a housing 101 removed, and Fig. 1C is a perspective view of the reflow oven 100 shown in Fig. 1B in an open state, to clearly show various components of the reflow oven 100 and a relationship between the various components.

As shown in Fig. 1A, the reflow oven 100 comprises a housing 101, and various components of the reflow oven 100 are disposed in the housing 101. As shown in Figs. 1B-1C, the reflow oven 100 comprises high temperature zones 102 and cooling zones 103. The reflow oven 100 comprises a reflow oven chamber 110 configured to perform high-temperature treatment and then cooling treatment on a workpiece (e.g., a circuit board) (not shown) passing therethrough. The reflow oven chamber 110 is provided with a plurality of high temperature zones 102 and a plurality of cooling zones 103. The reflow oven 100 further comprises a plurality of reflow oven chamber devices 111, which are disposed above and/or below the reflow oven chamber 110. Each reflow oven chamber device 111 is configured to deliver a gas flow to the reflow oven chamber 110 to process a workpiece in the reflow oven chamber 110. Reflow oven chamber devices 111 in the high temperature zones 102 deliver a hot gas flow to the reflow oven chamber 110 to perform high-temperature treatment on the workpiece. Reflow oven chamber devices 111 in the cooling zones 103 deliver a cold gas flow or a normal-temperature gas flow (e.g., an air flow in an external environment) to the reflow oven chamber 110 to cool the workpiece. Upper reflow oven chamber devices 111 are disposed above the reflow oven chamber 110, and lower reflow oven chamber devices 111 are disposed below the reflow oven chamber 110. Each upper reflow oven chamber device 111 is configured to deliver a gas flow to the reflow oven chamber 110 through a through hole (not shown) in a bottom surface 124 of the upper reflow oven chamber device. Each lower reflow oven chamber device 111 is configured to deliver a gas flow to the reflow oven chamber 110 through a through hole 126 in a top surface 125 of the lower reflow oven chamber device.

Fig. 2 is a perspective view of a system 300 for determining whether to clean a reflow oven 100 mounted on a part of the reflow oven 100 according to an embodiment of the present disclosure, to clearly show various components of the system 300, a relationship between the various components, and mounting positions of these components.

Fig. 2 shows a part of the reflow oven 100 that comprises a plurality of lower reflow oven chamber devices 111, above which a reflow oven chamber 110 is provided. This part of the reflow oven 100 comprises a high temperature zone 102 and a cooling zone 103. The system 300 is mounted to this part of the reflow oven 100. The system 300 comprises a collecting device 201, a weighing device 202, a control device 203, and an indicating device 204.

As shown in Fig. 2, the collecting device 201 is mounted in the cooling zone 103 of the reflow oven 100, and is configured to collect contaminants. During normal operation of the reflow oven 100, a workpiece (e.g., a circuit board) is conveyed through the reflow oven chamber 110 of the reflow oven 100 so as to be processed. Vapor contaminants evaporated from the high temperature zone 102 are condensed on a surface of the reflow oven chamber device 111 and a surface of the collecting device 201 after reaching the cooling zone 103. During the normal operation of the reflow oven 100, the collecting device 201 collects contaminants during the same period of time as the contaminants condensed on the surface of the reflow oven chamber device 111, so that the contaminants collected by the collecting device 201 can reflect a degree of contamination in the reflow oven 100. While contaminants are adhered (condensed) to the surface of the reflow oven chamber device 111, the contaminants are also adhered (condensed) to the collecting device 201, and thus the contaminants on the collecting device are collected. A collecting surface 601 of the collecting device 201 is configured to have the same material as that of a surface 125 of the reflow oven chamber device 111 (i.e., the top surface 125 of the lower reflow oven chamber device 111) in the cooling zone 103, such that the collecting surface 601 of the collecting device 201 allows the contaminants to be adhered with the same adhesion property as that of the surface 125 of the reflow oven chamber device 111. This configuration of the collecting device 201 facilitates the system 300 to accurately determine whether to clean the reflow oven 100. When the reflow oven 100 is initially mounted, the collecting device 201 is mounted in the reflow oven 100. After each cleaning of the reflow oven 100 is completed, the collecting device 201 is also cleaned accordingly, and is mounted in the reflow oven 100 after the cleaning is completed, so as to collect contaminants during the normal operation of the reflow oven 100.

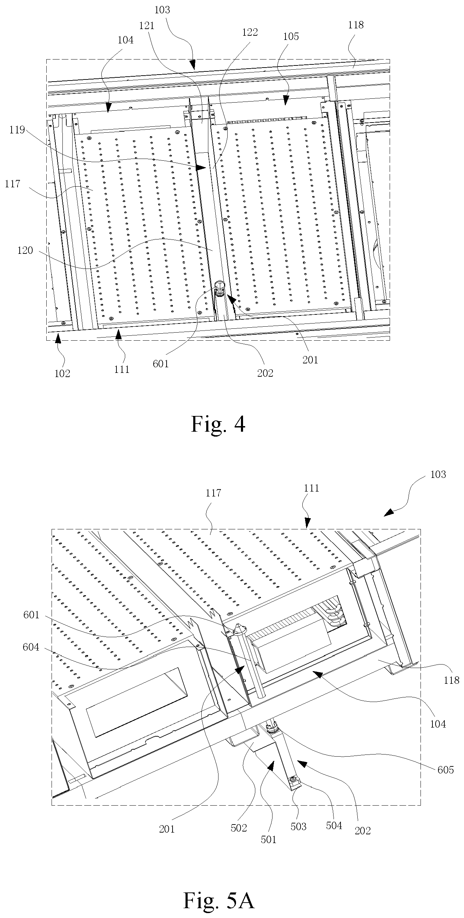

The collecting device 201 is mounted on the weighing device 202. In this embodiment, the weighing device 202 is mounted in the cooling zone 103 of the reflow oven 100. In other embodiments, the weighing device 202 is mounted outside the cooling zone 103 of the reflow oven 100 (see Figs. 5A-5B). The weighing device 202 is configured to weigh the collecting device 201 to obtain weight information of the collecting device 201. The weighing device 202 weighs the collecting device 201 with collected contaminants to obtain a sum of the weight information of the collecting device 201 and weight information of the collected contaminants. The weight information of the collecting device 201 with collected contaminants can reflect the degree of contamination in the reflow oven 100. The weighing device 202 is further configured to weigh the collecting device 201 without collected contaminants, to obtain initial weight information of the collecting device 201.

The control device 203 is connected to the weighing device 202, for example, via a connecting line (not shown). The control device 203 is configured to obtain the weight information of the collecting device 201 from the weighing device 202 in real time. The control device 203 is further configured to determine whether the reflow oven 100 needs to be cleaned based on the weight information of the collecting device 201 obtained from the weighing device 202. The control device 203 is further configured to output a control signal on whether the reflow oven 100 needs to be cleaned. For example, when it is determined that the reflow oven 100 needs to be cleaned, the control device 203 outputs a control signal indicating that the reflow oven 100 needs to be cleaned. Determining whether the reflow oven 100 needs to be cleaned comprises determining that the reflow oven 100 needs to be cleaned after a predetermined period of time, and determining that the reflow oven 100 needs to be cleaned immediately.

The indicating device 204 is connected to the control device 203. The indicating device 204 is configured to receive the control signal from the control device 203, and generate an indication indicative of whether the reflow oven 100 needs to be cleaned based on this control signal. The indication comprises a visual indication or an audible indication. In this embodiment, the indicating device 204 is an indicator lamp. In other embodiments, the indicating device 204 comprises a display, or other suitable indicating devices or structures.

When determining whether the reflow oven 100 needs to be cleaned, the control device 203 compares the weight information of the collecting device 201 with collected contaminants with a collecting device weight threshold. When the weight information of the collecting device 201 with collected contaminants reaches the collecting device weight threshold, the control device 203 determines that the reflow oven 100 needs to be cleaned, otherwise, the control device determines that the reflow oven 100 does not need to be cleaned. In an embodiment, the control device 203 obtains a sum of the initial weight information of the collecting device 201 without collected contaminants and a contaminant weight threshold as the collecting device weight threshold.

In another embodiment, when determining whether the reflow oven 100 needs to be cleaned, the control device 203 compares the weight information of the contaminants collected by the collecting device 201 with the contaminant weight threshold. When the weight information of the contaminants collected by the collecting device 201 reaches the contaminant weight threshold, the control device 203 determines that the reflow oven 100 needs to be cleaned, otherwise, the control device determines that the reflow oven 100 does not need to be cleaned. The control device 203 obtains the weight information of the contaminants collected by the collecting device 201 based on the initial weight information of the collecting device 201 without collected contaminants and the weight information of the collecting device 201 with collected contaminants, for example, based on a difference therebetween. In other embodiments, the control device 203 determines whether the reflow oven 100 needs to be cleaned by other suitable means.

In an embodiment, the initial weight information is either one of the following: before each determination of whether the reflow oven 100 needs to be cleaned, weight information of the collecting device 201 when initially mounted to the reflow oven 100, or weight information of the collecting device 201 when mounted to the reflow oven 100 after the cleaning is completed, at which time the collecting device 201 collects no contaminants.

In an embodiment, the contaminant weight threshold is obtained by means of historical data. For example, during multiple practical operations performed by a user, the control device 203 obtains a weight value of the contaminants collected by the collecting device 201 when the reflow oven 100 needs to be cleaned. More specifically, the weighing device 202 weighs the collecting device 201 without collected contaminants to obtain the initial weight information of the collecting device 201, and weighs the collecting device 201 with collected contaminants to obtain contamination weight information of the collecting device 201 when the reflow oven 100 needs to be cleaned. The control device 203 obtains these weight values of the collecting device 201 and processes these weight values, to obtain the weight value of the contaminants collected by the collecting device 201 when the reflow oven 100 needs to be cleaned, and uses the weight value as the contaminant weight threshold. In other embodiments, the control device 203 obtains the contaminant weight threshold by other suitable means.

In an embodiment, the control device 203 is a controller of the reflow oven 100. In another embodiment, the control device 203 is an additional control device, which is different from the controller of the reflow oven 100. In an embodiment, the indicating device 204 is an indicating device of the reflow oven 100. In another embodiment, the indicating device 204 is an additional indicating device, which is different from the indicating device of the reflow oven 100.

In another embodiment, the system 300 comprises a collecting device 201, a weighing device 202 and a control device 203, and the structures and operations of these devices are the same as those of the same devices described above.

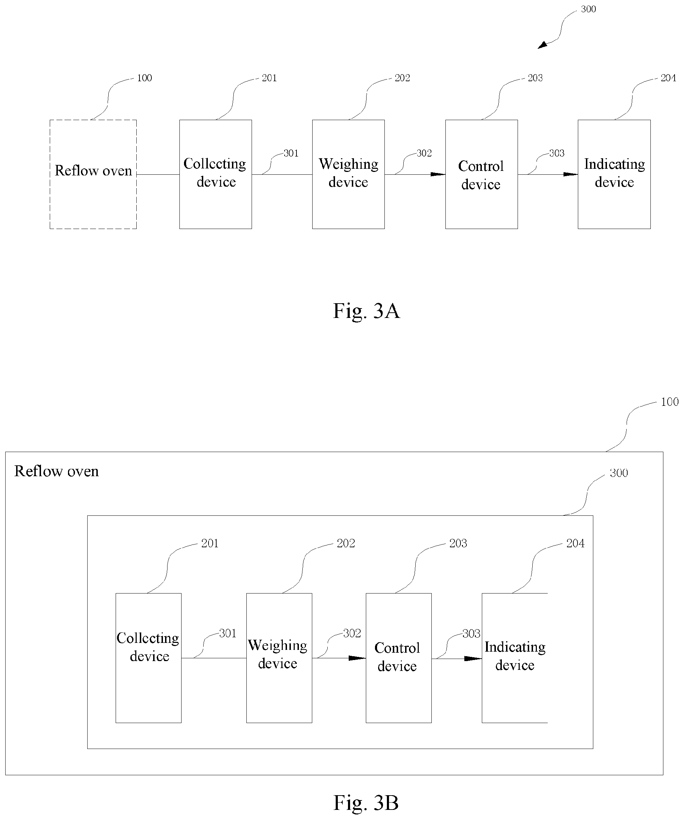

Fig. 3A is a block diagram of a system 300 for determining whether to clean a reflow oven 100 according to an embodiment of the present disclosure, and Fig. 3B is a block diagram of a system 300 for determining whether to clean a reflow oven 100 according to another embodiment of the present disclosure.

As shown in Fig. 3A, in an embodiment, the system 300 for determining whether to clean a reflow oven 100 comprises a collecting device 201, a weighing device 202, a control device 203, and an indicating device 204. The collecting device 201 is mounted in the cooling zone 103 of the reflow oven 100 (see Fig. 2), and is configured to collect contaminants. The collecting device 201 is mounted on the weighing device 202. A connecting line 301 between the collecting device 201 and the weighing device 202 shown in Fig. 3A denotes a physical connection. The weighing device 202 is configured to weigh the collecting device 201 to obtain weight information of the collecting device 201. The control device 203 is connected to the weighing device 202 via a connecting line 302 (e.g., a data line). The control device 203 is configured to receive the weight information of the collecting device 201 from the weighing device 202 by means of the connecting line 302, and determine whether the reflow oven 100 needs to be cleaned based on the weight information.

When determining whether the reflow oven 100 needs to be cleaned, the control device 203 compares the weight information of the collecting device 201 with collected contaminants with a collecting device weight threshold. When the weight information of the collecting device 201 with collected contaminants reaches the collecting device weight threshold, the control device 203 determines that the reflow oven 100 needs to be cleaned, otherwise, the control device determines that the reflow oven 100 does not need to be cleaned. In another embodiment, when determining whether the reflow oven 100 needs to be cleaned, the control device 203 compares the weight information of the contaminants collected by the collecting device 201 with the contaminant weight threshold. When the weight information of the contaminants collected by the collecting device 201 reaches the contaminant weight threshold, the control device 203 determines that the reflow oven 100 needs to be cleaned, otherwise, the control device determines that the reflow oven 100 does not need to be cleaned. In other embodiments, the control device 203 determines whether the reflow oven 100 needs to be cleaned by other suitable means. The control device 203 is further configured to output a control signal on whether the reflow oven 100 needs to be cleaned. The indicating device 204 is connected to the control device 203 via a connecting line 303. The indicating device 204 is configured to receive the control signal from the control device 203 by means of the connecting line 303, and generate an indication indicative of whether the reflow oven 100 needs to be cleaned based on this control signal.

In another embodiment, the system 300 comprises a collecting device 201, a weighing device 202 and a control device 203, and the structures and operations of these devices are the same as those of the same devices described above.

As shown in Fig. 3B, the reflow oven 100 comprises a system 300. The system 300 in Fig. 3B has the same structure as the system 300 in Fig. 3A.

Fig. 4 is a perspective view of an embodiment in which a collecting device 201 and a weighing device 202 in the system 300 shown in Fig. 2 are mounted in a reflow oven 100.

As shown in Fig. 4, the cooling zone 103 of the reflow oven 100 comprises a first cooling sub-zone 104 and a second cooling sub-zone 105. The first cooling sub-zone 104 is adjacent to the high temperature zone 102. The high temperature zone 102, the first cooling sub-zone 104 and the second cooling sub-zone 105 are disposed in sequence along a conveying direction of a workpiece in the reflow oven 100. The workpiece passes through the high temperature zone 102, the first cooling sub-zone 104 and the second cooling sub-zone 105 in sequence when conveyed in the reflow oven 100. The first cooling sub-zone 104 and the second cooling sub-zone 105 each include a lower reflow oven chamber device 111, which has an upper surface 117. The reflow oven chamber device 111 is mounted to a frame 118 of the reflow oven 100. An elongated cavity 119 is provided between the lower reflow oven chamber device 111 in the first cooling sub-zone 104 and the lower reflow oven chamber device 111 in the second cooling sub-zone 105, and is formed by a housing with an upper portion provided with an opening. The housing comprises a bottom portion 120, a front side (not visible in Fig. 4), a rear side 121, a left side (not visible in Fig. 4), and a right side 122. Part (e.g., a plate structure) of the frame 118 forms the bottom portion 120, the front side and the rear side 121 of the housing, and a right wall of the lower reflow oven chamber device 111 in the first cooling sub-zone 104 and a left wall of the lower reflow oven chamber device 111 in the second cooling sub-zone 105 respectively form the left side and the right side 122 of the housing.

The collecting device 201 is mounted on the weighing device 202. The weighing device 202 is mounted to a bottom portion 120 of the cavity 119. In an embodiment, the weighing device 202 is mounted to the bottom portion 120 of the cavity 119 by means of a fastener, such as a screw. In other embodiments, the weighing device 202 is mounted to the bottom portion 120 of the cavity 119 by other suitable means.

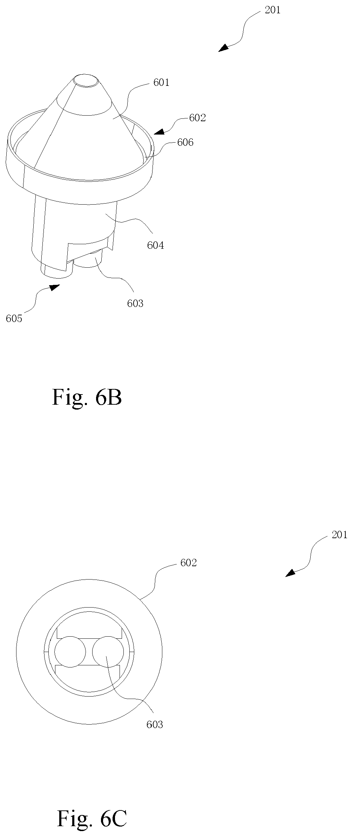

In the cooling zone 103, when contaminants are condensed on the surface 117 of the lower reflow oven chamber device 111, the contaminants are also condensed on the collecting surface 601 of the collecting device 201 (see Fig. 6B). The collecting surface 601 is configured to enable the contaminants to be adhered thereto. The collecting device 201 collects the contaminants adhered (condensed) thereto by means of the collecting surface 601. The weighing device 202 weighs the collecting device 201 to obtain weight information thereof. When the collecting device 201 collects no contaminants, the weighing device 202 obtains the initial weight information of the collecting device 201. When the collecting device 201 has collected contaminants, the weighing device 202 obtains the sum of the weight information of the collecting device 201 and the weight information of the collected contaminants.

As shown in Fig. 4, when the contaminant weight threshold is obtained by means of historical data, both the collecting device 201 and the weighing device 202 are mounted at a position in the reflow oven 100 during obtaining of the historical data, at which position contaminant weight threshold obtained is used by the control device 203 to determine whether the reflow oven 100 needs to be cleaned.

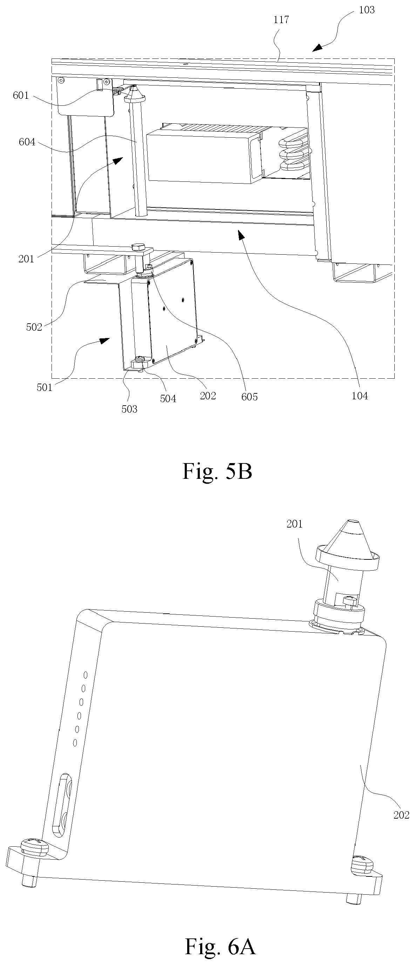

Fig. 5A is a perspective view of another embodiment in which a collecting device 201 and a weighing device 202 in the system 300 shown in Fig. 2 are mounted in a reflow oven 100, and Fig. 5B is a partial enlarged view of Fig. 5A.

As shown in Figs. 5A-5B, the weighing device 202 is mounted outside the cooling zone 103, and the collecting device 201 is mounted on the weighing device 202. A bottom end 605 of the collecting device 201 is mounted to the weighing device 202. A main body portion 604 of the collecting device 201 extends through the frame 118 into the cooling zone 103, such that the collecting surface 601 of the collecting device 201 is disposed in the cooling zone 103. In the cooling zone 103, when contaminants are condensed on the surface 117 of the lower reflow oven chamber device 111, the contaminants are also condensed on the collecting surface 601 of the collecting device 201.

The weighing device 202 is mounted to the reflow oven 100 via a mounting structure 501. In this embodiment, the mounting structure 501 is formed by a plate structure, which is bent into a Z shape and comprises an upper end 502 and a lower end 503. The upper end 502 is fixed to the frame 118, and the weighing device 202 is mounted on the lower end 503. The weighing device 202 is fixed to the lower end 503 of the mounting structure 501 by means of a fastener 504. The mounting structure 501 is of a rigid structure, and is configured to support the weighing device 202. In other embodiments, the mounting structure 501 comprises other suitable structures, to mount the weighing device 202 to the reflow oven 100.

As shown in Fig. 5A-5B, when the contaminant weight threshold is obtained by means of historical data, both the collecting device 201 and the weighing device 202 are mounted at a position in the reflow oven 100 during obtaining of the historical data, at which position contaminant weight threshold obtained is used by the control device 203 to determine whether the reflow oven 100 needs to be cleaned.

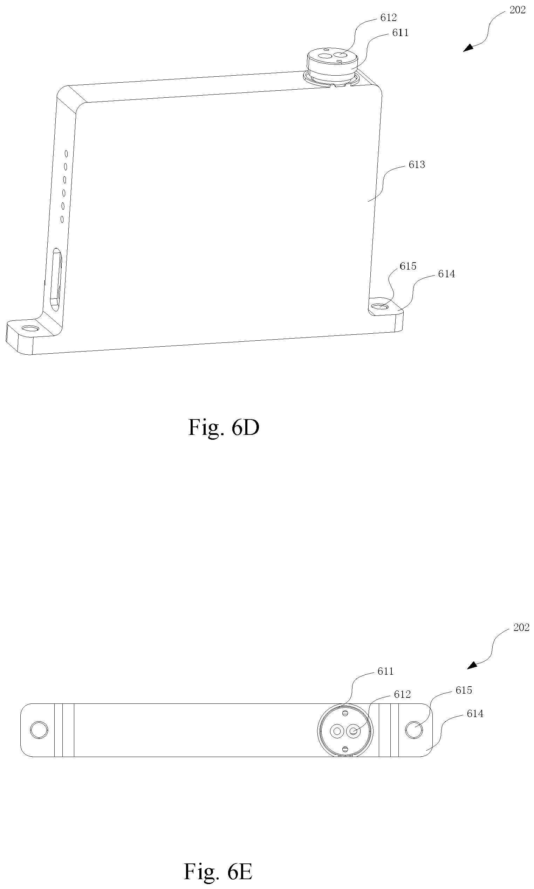

Fig. 6A is a perspective view of a collecting device 201 and a weighing device 202 in the system 300 shown in Fig. 2 when mounted together, Fig. 6B is a perspective view of the collecting device 201 shown in Fig. 6A, Fig. 6C is a bottom view of Fig. 6B, Fig. 6D is a perspective view of the weighing device 202 shown in Fig. 6A, and Fig. 6E is a top view of Fig. 6D.

As shown in Fig. 6A, the collecting device 201 is mounted on the weighing device 202. The weighing device 202 weighs the collecting device 201 thereon to obtain weight information of the collecting device. As shown in Figs. 6B-6C, the collecting device 201 comprises a collecting surface 601, a collecting recess 602, a main body portion 604, and a collection mounting portion 603. The collecting surface 601 enables the contaminants to be adhered thereto, and is configured to collect the contaminants adhered thereto. The collecting surface 601 is a tapered surface for reducing impact of a gas flow discharged from the upper reflow oven chamber device 111 on the weighing device 202 during the weighing of the contaminants on the collecting surface 601, so that the weighing is more accurate. When excessive contaminants are collected on the collecting surface 601, the contaminants will flow downwardly along the collecting surface 601 to the collecting recess 602. The collecting recess 602 is configured to collect the contaminants flowing from the collecting surface 601. The collecting recess 602 is communicated with a bottom portion of the collecting surface 601 to collect the contaminants flowing downwardly from the collecting surface 601, so as to prevent the contaminants collected on the collecting surface 601 from flowing out of the collecting device 201, which otherwise results in inaccurate collection of the contaminants by the collecting device 201. The collecting recess 602 collects the contaminants flowing from the collecting surface 601, so that the collecting device 201 can collect the contaminants more accurately. A recess portion of the collecting recess 602 is disposed toward the collecting surface 601.

The main body portion 604 is substantially cylindrical. The main body portion 604 extends downwardly from the collecting recess 602 to the bottom end 605 of the collecting device 201. The collection mounting portion 603 is disposed at the bottom end 605 of the collecting device 201. The collection mounting portion 603 is configured to be removably mounted to the weighing device 202, for example, to a first mounting portion 611 of the weighing device 202 (see Figs. 6D-6E), such that the collecting device 201 is mounted to the weighing device 202. The collection mounting portion 603 is cylindrical. In this embodiment, the collecting device 201 comprises two collection mounting portions 603. In other embodiments, the collecting device 201 comprises a different number of collection mounting portions 603.

As shown in Figs. 6D-6E, the weighing device 202 comprises the first mounting portion 611, a main body portion 613, and a second mounting portion 614. The first mounting portion 611 is configured to enable the collecting device 201 to be mounted to the weighing device 202. The first mounting portion 611 comprises a receiving hole 612, which is configured to receive the collection mounting portion 603 of the collecting device 201. In this embodiment, the first mounting portion 611 is substantially cylindrical, and the receiving hole 612 is cylindrical. The collection mounting portion 603 of the collecting device 201 is inserted into the receiving hole 612 of the weighing device 202, such that the collecting device 201 is mounted to the weighing device 202. The inner diameter of the receiving hole 612 is slightly greater than the outer diameter of the collection mounting portion 603, such that the collection mounting portion 603 of the collecting device 201 can be inserted into the receiving hole 612 of the weighing device 202. In other embodiments, the first mounting portion 611 comprises other suitable structures, and the receiving hole 612 comprises other suitable structures. The first mounting portion 611 is mounted on the main body portion 613. A weighing mechanism is provided in the main body portion 613, and is configured to weigh an object provided thereon. The second mounting portion 614 is configured to enable the weighing device 202 to be mounted to the reflow oven 100. The second mounting portion 614 extends from the main body portion 613, for example, extends outwardly from a bottom portion of a side surface of the main body portion 613. In this embodiment, the second mounting portion 614 is a flange. The second mounting portion 614 comprises an opening 615. A fastener, such as a screw, can pass through the opening 615 of the weighing device 202 to fasten the weighing device 202 to the reflow oven 100. In an embodiment, the weighing device 202 is a precision balance. In an embodiment, the precision balance has a measurement range of 300 g and a resolution accuracy of 5 mg. In other embodiments, the weighing device 202 comprises other suitable devices.

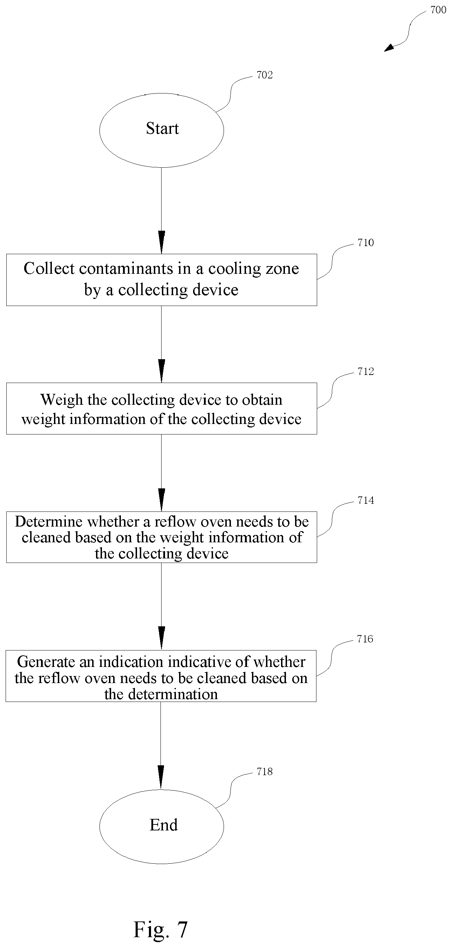

Fig. 7 is a flowchart of a method 700 for determining whether to clean a reflow oven 100 according to the present disclosure.

As shown in Fig. 7, at step 702, the method 700 for determining whether to clean a reflow oven 100 starts. Then, the process proceeds from step 702 to step 710.

At step 710, contaminants are collected in the cooling zone 103 by a collecting device 201. In an embodiment, the collecting device 201 is arranged in a first cooling sub-zone 104 of the cooling zone 103, and the contaminants adhered to the collecting device are collected by the collecting device 201. In another embodiment, the collecting device 201 is arranged in a spacing between the first cooling sub-zone 104 of the cooling zone 103 and a second cooling sub-zone 105 of the cooling zone 103, and the contaminants adhered to the collecting device are collected by the collecting device 201. The high temperature zone 102, the first cooling sub-zone 104 and the second cooling sub-zone 105 of the reflow oven 100 are disposed in sequence along a conveying direction of a workpiece in the reflow oven 100. Then, the process proceeds from step 710 to step 712.

At step 712, the collecting device 201 is weighed to obtain weight information of the collecting device 201. Weighing the collecting device 201 to obtain weight information of the collecting device 201 comprises weighing the collecting device 201 without collected contaminants to obtain the initial weight information of the collecting device 201, and weighing the collecting device 201 with collected contaminants to obtain the weight information of the collecting device 201. Then, the process proceeds from step 712 to step 714.

At step 714, it is determined whether the reflow oven 100 needs to be cleaned based on the weight information of the collecting device 201. Determining whether the reflow oven 100 needs to be cleaned based on the weight information of the collecting device 201 comprises determining whether the reflow oven 100 needs to be cleaned based on whether the weight information of the collecting device 201 with collected contaminants reaches a collecting device weight threshold, and determining whether the reflow oven 100 needs to be cleaned based on whether the weight information of the contaminants collected by the collecting device 201 reaches a contaminant weight threshold. Determining whether the reflow oven 100 needs to be cleaned comprises determining that the reflow oven 100 needs to be cleaned after a predetermined period of time, and determining that the reflow oven 100 needs to be cleaned immediately. Then, the process proceeds from step 714 to step 716.

At step 716, an indication indicative of whether the reflow oven 100 needs to be cleaned is generated based on the determination. Generating an indication indicative of whether the reflow oven 100 needs to be cleaned comprises generating a visual indication or an audible indication indicative of whether the reflow oven 100 needs to be cleaned. Then, the process proceeds from step 716 to step 718, and the method 700 for determining cleaning of a reflow oven 100 ends.

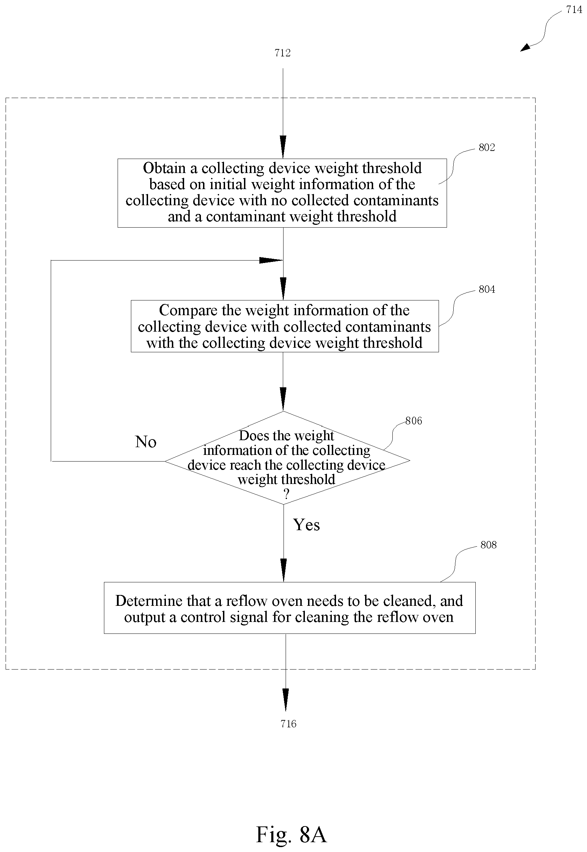

Determining whether the reflow oven 100 needs to be cleaned at step 714 comprises determining whether the weight information of the collecting device 201 with collected contaminants reaches the collecting device weight threshold. If the weight information of the collecting device 201 with collected contaminants reaches the collecting device weight threshold, it is determined that the reflow oven 100 needs to be cleaned, otherwise, it is determined that the reflow oven 100 does not need to be cleaned. In another embodiment, determining whether the reflow oven 100 needs to be cleaned at step 714 comprises determining whether the weight information of the contaminants collected by the collecting device 201 reaches the contaminant weight threshold. If the weight information of the contaminants collected by the collecting device 201 reaches the contaminant weight threshold, it is determined that the reflow oven 100 needs to be cleaned, otherwise, it is determined that the reflow oven 100 does not need to be cleaned. Figs. 8A-B show specific operations of step 714.

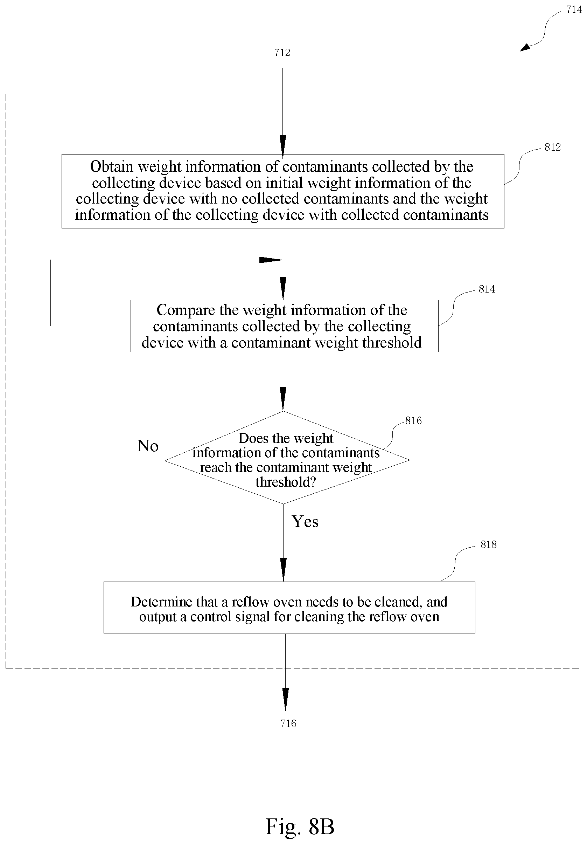

Fig. 8A is a detailed flowchart of an embodiment of step 714 shown in Fig. 7, and Fig. 8B is a detailed flowchart of another embodiment of step 714 shown in Fig. 7. As shown in Fig. 7, at step 714, it is determined whether the reflow oven 100 needs to be cleaned based on the weight information of the collecting device 201.

As shown in Fig. 8A, the process proceeds from step 712 in Fig. 7 to step 802. At step 802, the collecting device weight threshold is obtained based on the initial weight information of the collecting device 201 without collected contaminants and a contaminant weight threshold. The initial weight information of the collecting device 201 without collected contaminants is obtained, and a sum of the initial weight information of the collecting device 201 and the contaminant weight threshold is obtained as the collecting device weight threshold. The initial weight information is either one of the following: before each determination of whether the reflow oven 100 needs to be cleaned, weight information of the collecting device 201 when initially mounted to the reflow oven 100 or weight information of the collecting device 201 when mounted to the reflow oven 100 after the cleaning is completed, at which time the collecting device 201 collects no contaminants. Then, the process proceeds from step 802 to step 804.

At step 804, the weight information of the collecting device 201 with collected contaminants is compared with the collecting device weight threshold. Then, the process proceeds from step 804 to step 806.

At step 806, it is determined whether the weight information of the collecting device 201 with collected contaminants reaches the collecting device weight threshold. If the weight information of the collecting device 201 with collected contaminants reaches the collecting device weight threshold, the process proceeds to step 808. Otherwise, the process proceeds to step 804, at which updated weight information of the collecting device 201 with collected contaminants is compared with the collecting device weight threshold to determine whether the reflow oven 100 needs to be cleaned.

At step 808, it is determined that the reflow oven 100 needs to be cleaned, and a control signal for cleaning the reflow oven 100 is output. Then, the process proceeds from step 808 to step 716 in Fig. 7.

As shown in Fig. 8B, the process proceeds from step 712 in Fig. 7 to step 812.

At step 812, the weight information of the contaminants collected by the collecting device 201 is obtained based on the initial weight information of the collecting device 201 without collected contaminants and the weight information of the collecting device 201 with collected contaminants. The initial weight information of the collecting device 201 without collected contaminants is obtained, the weight information of the collecting device 201 with collected contaminants is obtained, and a difference between the initial weight information of the collecting device 201 and the weight information of the collecting device 201 with collected contaminants is obtained as the weight information of the contaminants collected by the collecting device 201. The initial weight information is either one of the following: before each determination of whether the reflow oven 100 needs to be cleaned, weight information of the collecting device 201 when initially mounted to the reflow oven 100 or weight information of the collecting device 201 mounted to the reflow oven 100 after the cleaning is completed, at which time the collecting device 201 collects no contaminants. Then, the process proceeds from step 812 to step 814.

At step 814, the weight information of the contaminants collected by the collecting device 201 is compared with a contaminant weight threshold. Then, the process proceeds from step 814 to step 816.

At step 816, it is determined whether the weight information of the contaminants collected by the collecting device 201 reaches the contaminant weight threshold. If the weight information of the contaminants collected by the collecting device 201 reaches the contaminant weight threshold, the process proceeds to step 818. Otherwise, the process proceeds to step 814, at which updated weight information of the contaminants collected by the collecting device 201 is compared with the contaminant weight threshold to determine whether the reflow oven 100 needs to be cleaned.

At step 818, it is determined that the reflow oven 100 needs to be cleaned, and a control signal for cleaning the reflow oven 100 is output. Then, the process proceeds from step 818 to step 716 in Fig. 7.

In an embodiment, the contaminant weight threshold is obtained by means of historical data. For example, during multiple practical operations by a user, the control device 203 obtains a weight value of the contaminants collected by the collecting device 201 when the reflow oven 100 needs to be cleaned. More specifically, the weighing device 202 weighs the collecting device 201 without collected contaminants to obtain the initial weight information of the collecting device 201, and weighs the collecting device 201 with collected contaminants to obtain contamination weight information of the collecting device 201 when the reflow oven 100 needs to be cleaned. The control device 203 obtains these weight values of the collecting device 201 and processes these weight values, to obtain the weight value of the contaminants collected by the collecting device 201 when the reflow oven 100 needs to be cleaned, and uses the weight value as the contaminant weight threshold. In other embodiments, the control device 203 obtains the contaminant weight threshold by other suitable means.

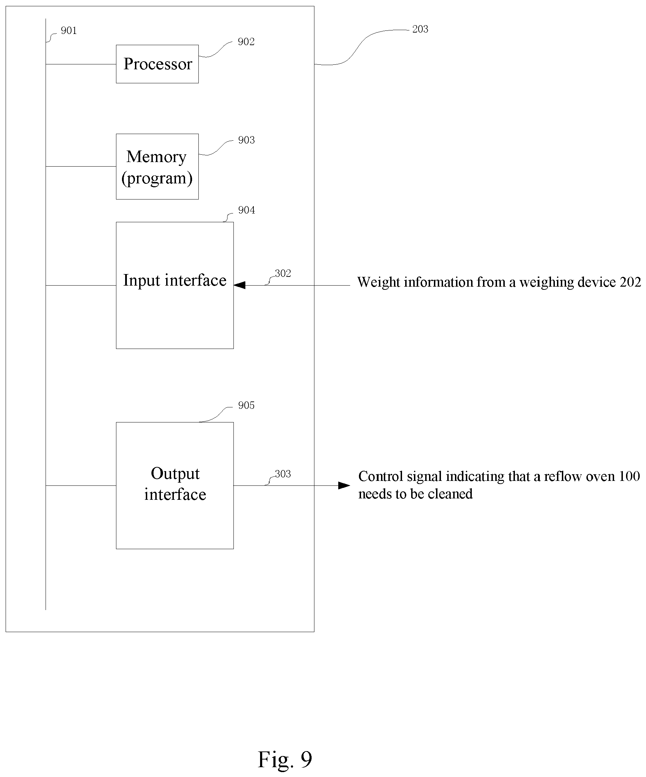

Fig. 9 is a block diagram of the control device 203 shown in Figs. 3A-3B. As shown in Fig. 9, the control device 203 comprises a bus 901, a processor 902, a memory 903, an input interface 904, and an output interface 905. The processor 902, the memory 903, the input interface 904 and the output interface 905 are connected to the bus 901. The processor 902 may read programs (or instructions) from the memory 903 and execute the programs (or the instructions) to process data and/or control each component of the reflow oven 100. The processor 902 may further write data or programs (or instructions) into the memory 903. The memory 903 may store the programs (instructions) or the data. By executing the instructions in the memory 903, the processor 902 may control the memory 903, the input interface 904, and the output interface 905.

The input interface 904 is configured to receive weight information from the weighing device 202 by means of a connecting line 302. The input interface 904 is further configured to convert the received weight information into a signal recognizable by the processor 902 and output the signal to the processor 902. The processor 902 is configured to process (e.g., calculate and determine) the received signal to output a control signal that the reflow oven 100 needs to be cleaned.

The output interface 905 is configured to receive the control signal from the processor 902, convert the control signal into an output signal suitable for an indicating device 204, and send the output signal to the indicating device 204 by means of a connecting line 303, such that the indicating device 204 generates an indication that the reflow oven 100 needs to be cleaned, which, for example, comprises an indication that the reflow oven 100 needs to be cleaned after a predetermined period of time, and an indication that the reflow oven 100 needs to be cleaned immediately.

Although the present disclosure is described with reference to the examples of embodiments outlined above, various alternatives, modifications, variations, improvements and/or substantial equivalents, which are known or anticipated at present or to be anticipated before long, may be obvious to those of at least ordinary skill in the art. In addition, the technical effects and/or technical problems described in this specification are exemplary rather than limiting. Therefore, the disclosure in this specification may be used to solve other technical problems and have other technical effects and/or may solve other technical problems. Accordingly, the examples of the embodiments of the present disclosure as set forth above are intended to be illustrative rather than limiting. Various changes may be made without departing from the spirit or scope of the present disclosure. Therefore, the present disclosure is intended to embrace all known or earlier disclosed alternatives, modifications, variations, improvements and/or substantial equivalents.

Certain embodiments of the invention are described in the following clauses:
Clause 1. A system (300) for determining whether to clean a reflow oven (100) comprising a high temperature zone (102) and a cooling zone (103), the system (300) comprising:
   a collecting device (201) disposed in the cooling zone (103) and configured to collect contaminants;
   a weighing device (202), the collecting device (201) being mounted on the weighing device (202), and the weighing device (202) being configured to weigh the collecting device (201) to obtain weight information of the collecting device (201); and
   a control device (203) configured to determine whether the reflow oven (100) needs to be cleaned based on the weight information of the collecting device (201).
Clause 2. The system (300) according to clause 1, wherein
   the collecting device (201) is disposed in a first cooling sub-zone (104) of the cooling zone (103), or disposed in an intermediate zone between the first cooling sub-zone (104) of the cooling zone (103) and a second cooling sub-zone (105) of the cooling zone (103),
   wherein the high temperature zone (102), the first cooling sub-zone (104) and the second cooling sub-zone (105) are disposed in sequence along a conveying direction of a workpiece in the reflow oven (100).
Clause 3. The system (300) according to clause 1, wherein
   the weighing device (202) is disposed inside or outside the cooling zone (103).
Clause 4. The system (300) according to clause 1, wherein the collecting device (201) comprises:
   a collecting surface (601) configured to enable the contaminants to be adhered thereto; and
   a collecting recess (602) communicated with the collecting surface (601) and configured to collect the contaminants flowing from the collecting surface (601),
   wherein the collecting surface (601) is a tapered surface.
Clause 5. The system (300) according to clause 4, wherein
   the collecting surface (601) of the collecting device (201) is configured to have the same material as that of a surface of a reflow oven chamber device (111) in the cooling zone (103), such that the collecting surface (601) of the collecting device (201) allows the contaminants to be adhered with the same adhesion properties as that of the surface of the reflow oven chamber device (111).
Clause 6. The system (300) according to clause 1, wherein
   the weighing device (202) is a precision balance.
Clause 7. The system (300) according to clause 1, wherein the control device (203) is further configured to:
   compare the weight information of the collecting device (201) with collected contaminants with a collecting device weight threshold, and determine that the reflow oven (100) needs to be cleaned if the weight information of the collecting device (201) with collected contaminants reaches the collecting device weight threshold; or
   compare the weight information of the contaminants collected by the collecting device (201) with a contaminant weight threshold, and determine that the reflow oven (100) needs to be cleaned if the weight information of the contaminants collected by the collecting device (201) reaches the contaminant weight threshold.
Clause 8. The system (300) according to clause 1, wherein the control device (203) is further configured to:
   determine that the reflow oven (100) needs to be cleaned after a predetermined period of time based on the weight information of the collecting device (201); or
   determine that the reflow oven (100) needs to be cleaned immediately based on the weight information of the collecting device (201).
Clause 9. The system (300) according to clause 1, wherein
   the control device (203) is a controller of the reflow oven (100) or different from the controller of the reflow oven (100).
Clause 10. The system (300) according to clause 1, wherein the system (300) further comprises:
   an indicating device (204) configured to generate an indication indicative of whether the reflow oven (100) needs to be cleaned based on a signal received from the control device (203), the indication comprises a visual indication or an audible indication.
Clause 11. A method (400) for determining whether to clean reflow oven (100) comprising a high temperature zone (102) and a cooling zone (103), the method (400) comprising:
   collecting contaminants in the cooling zone (103) by a collecting device (201);
   weighing the collecting device (201) to obtain weight information of the collecting device (201); and
   determining whether the reflow oven (100) needs to be cleaned based on the weight information of the collecting device (201).
Clause 12. The method (400) according to clause 11, wherein determining whether the reflow oven (100) needs to be cleaned based on the weight information of the collecting device (201) comprises:
   comparing the weight information of the collecting device (201) with collected contaminants with a collecting device weight threshold; and
   determining that the reflow oven (100) needs to be cleaned if the weight information of the collecting device (201) with collected contaminants reaches the collecting device weight threshold.
Clause 13. The method (400) according to clause 12, wherein the method (400) further comprises:
   obtaining initial weight information of the collecting device (201) without collected contaminants; and
   obtaining a sum of the initial weight information of the collecting device (201) and a contaminant weight threshold as the collecting device weight threshold.
Clause 14. The method (400) according to clause 11, wherein determining whether the reflow oven (100) needs to be cleaned based on the weight information of the collecting device (201) comprises:
   obtaining the weight information of the contaminants collected by the collecting device (201) based on the initial weight information of the collecting device (201) without collected contaminants and the weight information of the collecting device (201) with collected contaminants;
   comparing the weight information of the contaminants collected by the collecting device (201) with a contaminant weight threshold; and
   determining that the reflow oven (100) needs to be cleaned if the weight information of the contaminants collected by the collecting device (201) reaches the contaminant weight threshold.
Clause 15. The method (400) according to clause 13 or 14, wherein the initial weight information of the collecting device (201) without collected contaminants is obtained by:
   weighing the collecting device (201) without collected contaminants after each cleaning of the reflow oven (100), so as to obtain the initial weight information of the collecting device (201).
Clause 16. The method (400) according to clause 11, wherein collecting contaminants in the cooling zone (103) by a collecting device (201) comprises:
   arranging the collecting device (201) in a first cooling sub-zone (104) of the cooling zone (103), and collecting, by the collecting device (201), the contaminants adhered thereto; or
   arranging the collecting device (201) in an intermediate zone between the first cooling sub-zone (104) of the cooling zone (103) and a second cooling sub-zone (105) of the cooling zone (103), and collecting, by the collecting device (201), the contaminants adhered thereto,
   wherein the high temperature zone (102), the first cooling sub-zone (104) and the second cooling sub-zone (105) are disposed in sequence along a conveying direction of a workpiece in the reflow oven (100).
Clause 17. The method (400) according to clause 11, wherein determining whether the reflow oven (100) needs to be cleaned comprises:
   determining that the reflow oven (100) needs to be cleaned after a predetermined period of time; and
   determining that the reflow oven (100) needs to be cleaned immediately.
Clause 18. The method (400) according to clause 11, wherein the method (400) further comprises:
   generating an indication indicative of whether the reflow oven (100) needs to be cleaned based on the determination,
   wherein generating an indication indicative of whether the reflow oven (100) needs to be cleaned comprises: generating a visual indication or an audible indication indicative of whether the reflow oven (100) needs to be cleaned.
Clause 19. A reflow oven (100), comprising:
   the system (300) for determining whether to clean a reflow oven (100) according to clauses 1-10.
Clause 20. A reflow oven (100) for performing the method (400) according to clauses 11-18.

## Claims

1. A system (300) for determining whether to clean a reflow oven (100) comprising a high temperature zone (102) and a cooling zone (103), the system (300) comprising:
a collecting device (201) disposed in the cooling zone (103) and configured to collect contaminants;
a weighing device (202), the collecting device (201) being mounted on the weighing device (202), and the weighing device (202) being configured to weigh the collecting device (201) to obtain weight information of the collecting device (201); and
a control device (203) configured to determine whether the reflow oven (100) needs to be cleaned based on the weight information of the collecting device (201).

2. The system (300) according to claim 1, wherein
the collecting device (201) is disposed in a first cooling sub-zone (104) of the cooling zone (103), or disposed in an intermediate zone between the first cooling sub-zone (104) of the cooling zone (103) and a second cooling sub-zone (105) of the cooling zone (103),
wherein the high temperature zone (102), the first cooling sub-zone (104) and the second cooling sub-zone (105) are disposed in sequence along a conveying direction of a workpiece in the reflow oven (100), or wherein
the weighing device (202) is disposed inside or outside the cooling zone (103).

3. The system (300) according to claim 1, wherein the collecting device (201) comprises:
a collecting surface (601) configured to enable the contaminants to be adhered thereto; and
a collecting recess (602) communicated with the collecting surface (601) and configured to collect the contaminants flowing from the collecting surface (601),
wherein the collecting surface (601) is a tapered surface, and optionally wherein
the collecting surface (601) of the collecting device (201) is configured to have the same material as that of a surface of a reflow oven chamber device (111) in the cooling zone (103), such that the collecting surface (601) of the collecting device (201) allows the contaminants to be adhered with the same adhesion properties as that of the surface of the reflow oven chamber device (111).

4. The system (300) according to claim 1, wherein
the weighing device (202) is a precision balance, or wherein
the control device (203) is further configured to:
compare the weight information of the collecting device (201) with collected contaminants with a collecting device weight threshold, and determine that the reflow oven (100) needs to be cleaned if the weight information of the collecting device (201) with collected contaminants reaches the collecting device weight threshold; or
compare the weight information of the contaminants collected by the collecting device (201) with a contaminant weight threshold, and determine that the reflow oven (100) needs to be cleaned if the weight information of the contaminants collected by the collecting device (201) reaches the contaminant weight threshold.

5. The system (300) according to claim 1, wherein the control device (203) is further configured to:
determine that the reflow oven (100) needs to be cleaned after a predetermined period of time based on the weight information of the collecting device (201); or
determine that the reflow oven (100) needs to be cleaned immediately based on the weight information of the collecting device (201).

6. The system (300) according to claim 1, wherein
the control device (203) is a controller of the reflow oven (100) or different from the controller of the reflow oven (100), or wherein
the system (300) further comprises:
an indicating device (204) configured to generate an indication indicative of whether the reflow oven (100) needs to be cleaned based on a signal received from the control device (203), the indication comprises a visual indication or an audible indication.

7. A method (400) for determining whether to clean reflow oven (100) comprising a high temperature zone (102) and a cooling zone (103), the method (400) comprising:
collecting contaminants in the cooling zone (103) by a collecting device (201);
weighing the collecting device (201) to obtain weight information of the collecting device (201); and
determining whether the reflow oven (100) needs to be cleaned based on the weight information of the collecting device (201).

8. The method (400) according to claim 7, wherein determining whether the reflow oven (100) needs to be cleaned based on the weight information of the collecting device (201) comprises:
comparing the weight information of the collecting device (201) with collected contaminants with a collecting device weight threshold; and
determining that the reflow oven (100) needs to be cleaned if the weight information of the collecting device (201) with collected contaminants reaches the collecting device weight threshold.

9. The method (400) according to claim 8, wherein the method (400) further comprises:
obtaining initial weight information of the collecting device (201) without collected contaminants; and
obtaining a sum of the initial weight information of the collecting device (201) and a contaminant weight threshold as the collecting device weight threshold.

10. The method (400) according to claim 7, wherein determining whether the reflow oven (100) needs to be cleaned based on the weight information of the collecting device (201) comprises:
obtaining the weight information of the contaminants collected by the collecting device (201) based on the initial weight information of the collecting device (201) without collected contaminants and the weight information of the collecting device (201) with collected contaminants;
comparing the weight information of the contaminants collected by the collecting device (201) with a contaminant weight threshold; and
determining that the reflow oven (100) needs to be cleaned if the weight information of the contaminants collected by the collecting device (201) reaches the contaminant weight threshold.

11. The method (400) according to claim 9 or 10, wherein the initial weight information of the collecting device (201) without collected contaminants is obtained by:
weighing the collecting device (201) without collected contaminants after each cleaning of the reflow oven (100), so as to obtain the initial weight information of the collecting device (201).

12. The method (400) according to claim 7, wherein collecting contaminants in the cooling zone (103) by a collecting device (201) comprises:
arranging the collecting device (201) in a first cooling sub-zone (104) of the cooling zone (103), and collecting, by the collecting device (201), the contaminants adhered thereto; or
arranging the collecting device (201) in an intermediate zone between the first cooling sub-zone (104) of the cooling zone (103) and a second cooling sub-zone (105) of the cooling zone (103), and collecting, by the collecting device (201), the contaminants adhered thereto,
wherein the high temperature zone (102), the first cooling sub-zone (104) and the second cooling sub-zone (105) are disposed in sequence along a conveying direction of a workpiece in the reflow oven (100).

13. The method (400) according to claim 7, wherein determining whether the reflow oven (100) needs to be cleaned comprises:
determining that the reflow oven (100) needs to be cleaned after a predetermined period of time; and
determining that the reflow oven (100) needs to be cleaned immediately, or wherein
the method (400) further comprises:
generating an indication indicative of whether the reflow oven (100) needs to be cleaned based on the determination,
wherein generating an indication indicative of whether the reflow oven (100) needs to be cleaned comprises: generating a visual indication or an audible indication indicative of whether the reflow oven (100) needs to be cleaned.

14. A reflow oven (100), comprising:
the system (300) for determining whether to clean a reflow oven (100) according to claims 1-6.

15. A reflow oven (100) for performing the method (400) according to claims 7-13.
